# EUROPÄISCHE PATENTSCHRIFT

(11) **EP 3 387 749 B1**
(45) Veröffentlichungstag und Bekanntmachung des Hinweises auf die Patenterteilung: **08.12.2021**
(21) Anmeldenummer: 16794236.6
(22) Anmeldetag: 28.10.2016
(51) Int. Cl.: H03K 17/06

(54) **HIGH-SIDE-SCHALTER FÜR DIE STROMVERSORGUNG MINDESTENS EINES SENSORS**
HIGH-SIDE SWITCH FOR SUPPLYING POWER TO AT LEAST ONE SENSOR
COMMUTATEUR CÔTÉ HAUT POUR ALIMENTER EN COURANT AU MOINS UN CAPTEUR

(30) Priorität: 11.12.2015 DE 102015224956
(43) Veröffentlichungstag der Anmeldung: 17.10.2018
(73) Patentinhaber: Robert Bosch GmbH, 70442 Stuttgart (DE)
(72) Erfinder: WALKER, Thomas, 72127 Kusterdingen (DE); ARAIA, Layiney, 72793 Pfullingen (DE)
(86) Internationale Anmeldenummer: PCT/EP2016/076080
(87) Internationale Veröffentlichungsnummer: WO 2017/097497

(56) Entgegenhaltungen:
- DE-A1- 4 334 386
- DE-A1-102012 216 317

## Beschreibung

Die vorliegende Erfindung betrifft einen High-Side-Schalter für die Stromversorgung mindestens eines Sensors, welcher zwei Anschlüsse umfasst, die über einen Strompfad miteinander verbunden sind, innerhalb welchem ein Messtransistor und mindestens ein Widerstand einander in Reihe geschaltet sind, wobei ein Leistungstransistor dem Strompfad parallel geschaltet ist und ein Komparator zur Einregelung des Stromes durch den Messtransistor und den Leistungstransistor vorgesehen ist.

### Stand der Technik

High-Side-Schalter werden eingesetzt, um eine schaltbare Versorgung insbesondere von Sensoren, wie beispielsweise von Ultraschallsensoren zu gewährleisten. Für eine solche Versorgung ist es erforderlich, eine möglichst niederohmige Verbindung zwischen einer Energiequelle, wie beispielsweise einer Batterie, und den Versorgungsanschlüssen des jeweils mit Strom zu versorgenden Sensors sicherzustellen, wenn der Schalter geschlossen ist. Ist der High-Side-Schalter geöffnet, muss hingegen sichergestellt sein, dass die Verbindung zwischen der Energiequelle und dem Sensor möglichst hochohmig ist.

Sollen externe Kondensatoren am Anschluss beziehungsweise Terminal des Sensors mit einem begrenzten Strom umgeladen werden, so muss der Strom im beziehungsweise durch den High-Side-Schalter begrenzt werden. Um die Sensoren insbesondere für die Aufbringung der nötigen Sendeleistung dennoch mit einem hohen Strom bedienen zu können, müssten dann entweder mehrere High-Side-Schalter zum Einsatz kommen, oder es müsste eine große Toleranz in der Strombegrenzung hingenommen werden.

Im Stand der Technik kommen High-Side-Schalter zum Einsatz, welche einen Strom- oder Referenzpfad mit einem auch als Sensetransistor bezeichneten Messtransistor darin aufweisen. Zu diesem Messtransistor ist meist ein auch als Sensewiderstand bezeichneter (Mess-)Widerstand in Reihe geschaltet. Um einen möglichst geringen Einschaltwiderstand R_{DSon} des Messtransistors zu erhalten und um einen übermäßigen Spannungsabfall am (Mess-)Widerstand zu verhindern, wird dem Strom- oder Referenzpfad mit kleiner Fläche ein auch als Power-Transistor bezeichneter Leistungstransistor parallel geschaltet, welcher den maximalen Strom durch den High-Side-Schalter tragen soll.

Allerdings bedingt der (Mess-)Widerstand im Strom- beziehungsweise im Referenzpfad eine unerwünschte (Source-)Gegenkopplung, welche die Spannung am Steuereingang des Leistungstransistors verändert, was wiederum zu einer unerwünschten Erhöhung des Stromflusses durch den Leistungstransistor führt. Bei den nur zur Führung geringerer Ströme ausgelegten High-Side-Schaltern des Standes der Technik kann dieser Fehler vernachlässigt werden, da der Spannungsabfall hier am (Mess-)Widerstand deutlich kleiner ausfällt als die effektive Spannung am Steuereingang des Leistungstransistors. Bei höheren Strömen ist dieser Fehler aber nicht mehr vernachlässigbar.

Die DE 10 2012 216 317 A1 offenbart ein Leistungsmodul, welches eine Treiberschaltung zum Treiben eines IGBT eines Halbleiterelementes sowie eine Schutzschaltung enthält.

### Offenbarung der Erfindung

Erfindungsgemäß wird ein High-Side-Schalter für die Stromversorgung mindestens eines Sensors zur Verfügung gestellt, welcher zwei Anschlüsse sowie einen Strompfad umfasst, über welchen die Anschlüsse miteinander elektrisch leitfähig verbunden sind, und innerhalb welchem ein Messtransistor und mindestens zwei Widerstände einander in Reihe geschaltet sind. Ferner umfasst der High-Side-Schalter einen Leistungstransistor, welcher dem Strompfad parallel geschaltet ist sowie einen Komparator, welcher zwei Eingänge aufweist, von denen einer fix mit dem Strompfad verbunden und einer derart variabel mit dem Strompfad verbindbar ist, dass die Anzahl der zwischen den Verbindungspunkten der Eingänge mit dem Strompfad liegenden Widerstände veränderbar ist. Des Weiteren umfasst der Komparator einen Ausgang, welcher mit dem Steuereingang des Messtransistors und des Leistungstransistors elektrisch leitfähig verbunden ist. Eine erste kalibrierbare Stromquelle ist mit dem Steuereingang des Messtransistors elektrisch leitfähig verbunden.

Der Vorteil eines derartigen High-Side-Schalters liegt darin, dass einer sich aufgrund der Gegenkopplung der Widerstände ergebenden Fehlspannung am Steuereingang des Leistungstransistors und einer mit dieser einhergehenden unerwünschten Erhöhung des Stromes durch den Leistungstransistor durch die Beaufschlagung des Steuereingangs des Messtransistors mit einem Kompensationsstrom entgegengewirkt werden kann. Tritt eine unerwünschte Spannungsänderung am Steuereingang des Leistungstransistors beziehungsweise eine unerwünschte Erhöhung des Stromflusses durch den Leistungstransistor auf, kann der Steuereingang des Messtransistors mit einem Kompensationsstrom aus der ersten kalibrierbaren Stromquelle beaufschlagt werden, um eine Anpassung des Stromflusses durch den Strompfad zu erreichen. Ein Stromfehler wird so vermieden. Ziel der Erfindung ist es also, durch Zuschalten eines Kompensationsstromes auf den Steuereingang/das Gate des Sensetransistors, also des Messtransistors, diesen Fehler zu eliminieren. Mit anderen Worten ausgedrückt stellt die Erfindung eine kostengünstige - weil kein Mehraufwand durch zusätzliche Schalter verursacht wird - Variante der Darstellung eines niederohmigen Schalters bereit, der mit verschiedenen Strombegrenzungen arbeitet und es außerdem erlaubt, mit einer einfachen Zusatzbeschaltung diagnosefähig zu sein. Der erfindungsgemäße High-Side-Schalter erlaubt eine Umschaltung von mehreren Mess- beziehungsweise Sense-Strömen, ohne den Stromfehler im Leistungstransistor zu erhöhen.

Bevorzugt ist der Stromausgang der ersten kalibrierbaren Stromquelle mit dem Steuereingang des Messtransistors elektrisch leitfähig verbunden. Ferner bevorzugt ist der erste Anschluss des High-Side-Schalters elektrisch leitfähig mit einem der Pole eines Energiespeichers, insbesondere einer Batterie, beispielsweise der Batterie eines Kraftfahrzeuges verbindbar. Des Weiteren bevorzugt ist der zweite Anschluss des High-Side-Schalters elektrisch leitfähig mit dem Terminal mindestens eines Sensors, insbesondere eines Ultraschallsensors verbindbar.

Bevorzugt ist der erste der Eingänge des Komparators derart verstellbar ausgebildet, dass in einer ersten Stellung desselben ein Widerstand und in einer zweiten Stellung beide Widerstände zwischen den Verbindungspunkten der Eingänge mit dem Strompfad innerhalb des Strompfads liegen, wobei der High-Side-Schalter ferner ein Stellmittel zum Stellungswechsel des ersten Eingangs umfasst. In einer derartigen Ausführung des High-Side-Schalters kann der mit diesem verbundene Sensor mit mehreren in der Höhe verschiedenen Strömen versorgt werden, ist also eine präzise, stufenweise verstellbare Stromversorgung des Sensors möglich, welche sich an einer variablen Last zu orientieren in der Lage ist. Der erste der Eingänge fungiert dabei als Sense-Abgriff. In einer derartigen Ausführung erlaubt der High-Side-Schalter also eine Umschaltung von mehreren Senseströmen, ohne den Stromfehler im Leistungstransistor zu erhöhen.

In einer bevorzugten Ausführungsform weist der Komparator einen Emitterkomparator, insbesondere einen 18mV- Emitterkomparator auf, welcher einen Transkonduktanzverstärker umfasst. Emitterkomparatoren, insbesondere 18mV-Emitterkomparatoren, sind einfach im Aufbau und kostengünstig erhältlich. Bevorzugt ist der Komparator als 18mV-Komparator ausgeführt.

Vorzugsweise handelt es sich sowohl bei dem Messtransistor als auch bei dem Leistungstransistor um Feldeffekttransistoren mit gleicher Kanallänge L, wobei die Kanalweite des Leistungstransistors um ein Vielfaches größer ist als die Kanalweite des Messtransistors. Bevorzugt entspricht das Verhältnis aus der Kanalweite des Leistungstransistors zu der Kanalweite des Messtransistors einem Verhältnis von 10 zu 1.

Bevorzugt sind der Steuereingang des Messtransistors und der Steuereingang des Leistungstransistors über jeweils eine elektrisch leitfähige Verbindung an einem Kreuzungspunkt miteinander verbunden, wobei eine zweite kalibrierbare Stromquelle mit dem Kreuzungspunkt elektrisch leitfähig verbunden ist. Durch eine derartige zweite kalibrierbare Stromquelle wird verhindert, dass die Ausgangsstufe des Komparators unnötig belastet wird.

In einer bevorzugten Ausführungsform ist der Stromausgang der ersten kalibrierbaren Stromquelle elektrisch leitfähig mit der elektrisch leitfähigen Verbindung zwischen dem Steuereingang des Messtransistors und dem Kreuzungspunkt verbunden, wobei in dieser elektrisch leitfähigen Verbindung zwischen dem Steuereingang des Messtransistors und dem Kreuzungspunkt ferner ein Vorwiderstand angeordnet ist. In einer derartigen Ausführungsform ist der Kompensationsstrom, mit welchem der Steuereingang des Messtransistors zum Zwecke der Kompensation beaufschlagt wird, durch ein einfaches Mittel begrenzt.

Erfindungsgemäß ist die erste kalibrierbare Stromquelle dazu ausgebildet, eine sich aufgrund der Gegenkopplung der Widerstände am Steuereingang des Leistungstransistors ergebende Fehlspannung durch Zuschaltung eines ersten Kompensationsstromes auf den Steuereingang des Messtransistors zu kompensieren. In einer derartigen Ausführung des High-Side-Schalters wird der Steuereingang des Messtransistors mit gerade so viel Strom beaufschlagt, wie benötigt wird, um den sich aus der Fehlspannung am Steuereingang ergebenden Stromfehler im Stromfluss durch den Leistungstransistor zu kompensieren.

Ferner bevorzugt ist die zweite kalibrierbare Stromquelle dazu ausgebildet, einen zweiten Kompensationsstrom in den Kreuzungspunkt einzuspeisen, welcher dem ersten Kompensationsstrom entspricht. In einer solchen Ausführung ist der Ausgang des Komparators zusätzlich vor einer unnötigen Überlastung geschützt. Des Weiteren bevorzugt ist die zweite kalibrierbare Stromquelle dazu ausgebildet, einen zweiten Kompensationsstrom in den Kreuzungspunkt einzuspeisen, welcher von dem ersten Kompensationsstrom der ersten kalibrierbaren Stromquelle verschieden ist.

Vorzugsweise entspricht das Produkt aus dem Widerstandswert des Vorwiderstands und des ersten Kompensationsstromes im Betrieb des High-Side-Schalters dem Produkt aus dem durch den Komparator eingeregelten Maximalstrom durch den Messtransistor und der Summe aus den Widerstandswerten der mindestens zwei Widerstände. In einer derartigen Ausführung ist der Stromfehler im Wesentlichen vollständig reduziert. Unter dem Maximalstrom wird der Strom verstanden, welcher maximal fließen darf, ohne dass der Komparator die Spannung am Steuereingang des Messtransistors zurückregelt.

Bevorzugt ist die erste kalibrierbare Stromquelle dazu ausgebildet, den Stromfluss durch den Strompfad auf einen vorbestimmten Sollwert zu trimmen. Dadurch lässt sich der Stromfluss durch den Messtransistor und den Leistungstransistor sehr genau einstellen.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein erstes schematisches Ausführungsbeispiel eines erfindungsgemäßen High-Side-Schalters, und
Figur 2 ein zweites Ausführungsbeispiel eines erfindungsgemäßen High-Side-Schalters.

### Ausführungsformen der Erfindung

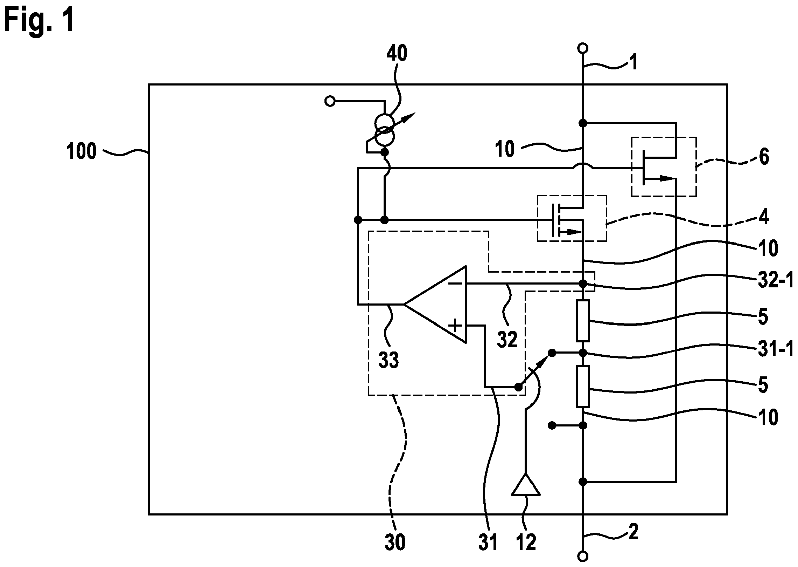

In der Figur 1 ist ein erstes schematisches Ausführungsbeispiel eines erfindungsgemäßen High-Side-Schalters 100 dargestellt. Das in Figur 1 dargestellte Ausführungsbeispiel ist lediglich schematisch und kann eine Vielzahl weiterer elektronischer Komponenten umfassen, auf welche in Figur 1 der besseren Übersichtlichkeit halber verzichtet wurde. Insbesondere können erfindungsgemäße High-Side-Schalter 100 neben den in Figur 1 dargestellten noch eine Vielzahl an weiteren elektronischen Komponenten umfassen, welche insbesondere der Stabilisierung des High-Side-Schalters 100 sowie dem Schutz der einzelnen in Figur 1 dargestellten Komponenten vor Überströmen und Überspannungen beziehungsweise vor einer Überlastung im weiteren Sinne dienen.

In diesem ersten Ausführungsbeispiel handelt es sich bei dem High-Side-Schalter 100 rein beispielhaft um einen High-Side-Schalter 100 für die Stromversorgung eines oder mehrerer Ultraschallsensoren. Es können aber auch erfindungsgemäße High-Side-Schalter 100 für die Stromversorgung eines oder mehrerer anderer Sensoren beziehungsweise anderer elektronischer Komponenten realisiert werden. Der High-Side-Schalter 100 umfasst zwei Anschlüsse 1, 2, also einen ersten und einen zweiten Anschluss 1, 2. Der erste Anschluss 1 dient in diesem ersten Ausführungsbeispiel rein beispielhaft der elektrisch leitfähigen Verbindung des High-Side-Schalters 100 mit einem Energiespeicher, bei welchem es sich beispielsweise um eine Batterie, insbesondere um die Batterie eines Kraftfahrzeuges handeln kann. Der zweite Anschluss 2 des High-Side-Schalters 100 dient in diesem ersten Ausführungsbeispiel rein beispielhaft der elektrisch leitfähigen Verbindung des High-Side-Schalters 100 mit einem Anschlussterminal des Ultraschallsensors. Der High-Side-Schalter 100 umfasst ferner einen Strompfad 10, über welchen der erste und zweite Anschluss 1, 2 miteinander elektrisch leitfähig verbunden sind, wobei innerhalb des Strompfads 10 ein Messtransistor 4 und in diesem ersten Ausführungsbeispiel rein beispielhaft zwei Widerstände 5 einander in Reihe geschaltet sind. Der Strompfad 10 stellt eine separate Versorgungsleitung dar, mittels welcher die Versorgung von mit dem High-Side-Schalter 100 verbindbaren Ultraschallsensoren geleistet wird. Bei dem auch als Sense-Transistor bezeichneten Messtransistor 4 handelt es sich in diesem Ausführungsbeispiel rein beispielhaft um einen N-Kanal-MOSFET. Es können aber auch beliebige andere Transistoren zum Einsatz kommen wie beispielsweise Bipolar-Transistoren oder dergleichen. Bei den beiden Widerständen 5 handelt es sich in diesem Ausführungsbeispiel rein beispielhaft um Messwiderstände, welche auch als Sense-Widerstände bezeichnet werden. In anderen Ausführungsbeispielen können auch mehr als zwei Widerstände 5 im Strompfad 10 einander in Reihe geschaltet sein.

Der High-Side-Schalter 100 umfasst ferner einen Leistungstransistor 6, welcher dem Strompfad 10 parallel geschaltet ist. Bei diesem auch als Power-Transistor bezeichneten Leistungstransistor 6 handelt es sich in diesem ersten Ausführungsbeispiel rein beispielhaft ebenfalls um einen Feldeffekttransistor mit einem N-Kanal, welcher zur Führung hoher Ströme ausgelegt ist. Es können aber auch andere Arten von Transistoren als Leistungstransistoren 6 innerhalb erfindungsgemäßer High-Side-Schalter 100 zum Einsatz kommen. Des Weiteren weist der High-Side-Schalter 100 einen Komparator 30 auf, welcher zwei Eingänge 31, 32 und einen Ausgang 33 umfasst. Bei dem Komparator 30 handelt es sich in diesem ersten Ausführungsbeispiel rein beispielhaft um einen einen Transkonduktanzverstärker umfassenden 18mV-Komparator. Ein Transkonduktanzverstärker wird auch als Operational Transconductance Amplifier oder einfach als OTA bezeichnet.

In diesem ersten Ausführungsbeispiel ist der 18mV-Komparator rein beispielhaft durch einen Emitterkomparator realisiert, bei welchem das Verhältnis von zwei Emittern zu einem Emitter ausgewertet wird. Es können aber auch beliebige andere Arten von Komparatoren 30 zum Einsatz kommen, welche auch einen Transkonduktanzverstärker nicht zwingend umfassen müssen.

Bei den zwei Eingängen 31, 32 des Komparators 30 handelt es sich in diesem ersten Ausführungsbeispiel rein beispielhaft um den invertierenden und den nicht-invertierenden Eingang des Transkonduktanzverstärkers des Komparators 30. In diesem ersten Ausführungsbeispiel ist der zweite, invertierende Eingang 32 des Komparators 30 an einem Verbindungspunkt 32-1 fix mit dem Strompfad 10 verbunden. Dieser fixe Verbindungspunkt 32-1 liegt in diesem ersten Ausführungsbeispiel rein beispielhaft zwischen dem Messtransistor 4 und der Gruppe der beiden unmittelbar aufeinander folgenden Widerstände 5. Der erste, nicht-invertierende Eingang 31 des Komparators 30 ist derart variabel mit dem Strompfad 10 verbindbar, dass die Anzahl der zwischen den Verbindungspunkten 31-1, 32-1 der Eingänge 31, 32 mit dem Strompfad 10 liegenden Widerstände 5 veränderbar ist. Mit anderen Worten ausgedrückt ist der erste Eingang 31 verstellbar ausgebildet und stellt einen Sense-Abgriff dar. Er kann in diesem ersten Ausführungsbeispiel zwischen zwei Stellungen wechseln. In einer ersten Stellung des ersten Eingangs 31 liegt der Verbindungspunkt 31-1 des ersten Eingangs 31 mit dem Strompfad 10 zwischen den beiden Widerständen 5, so dass zwischen den Verbindungspunkten 31-1, 32-1 der beiden Eingänge 31, 32 mit dem Strompfad 10 nur ein Widerstand 5 liegt. In einer zweiten Stellung des ersten Eingangs 31 liegt der Verbindungspunkt 31-1 des ersten Eingangs 31 mit dem Strompfad 10 zwischen dem zweiten Anschluss 2 des High-Side-Schalters 100 und der Gruppe der beiden unmittelbar aufeinander folgenden Widerstände 5. In dieser zweiten Stellung liegen beide Widerstände 5 zwischen den Verbindungspunkten 31-1, 32-1 der beiden Eingänge 31, 32 mit dem Strompfad 10.

In diesem ersten Ausführungsbeispiel umfasst der High-Side-Schalter 100 ferner ein Stellmittel 12 zum Stellungswechsel des ersten Eingangs 31. In Figur 1 ist dieses Stellmittel 12 zwar als mechanisches Mittel dargestellt, diese Darstellung ist jedoch wie bereits erwähnt nur schematisch und dient der besseren Verständlichkeit. Das Stellmittel 12 ist in diesem ersten Ausführungsbeispiel rein beispielhaft dazu ausgelegt, den Eingang 31 auf die Betätigung des Stellmittels 12 hin von der ersten Stellung in die zweite Stellung beziehungsweise von der zweiten Stellung in die erste Stellung zu überführen. Diese Überführung erfolgt dabei in diesem ersten Ausführungsbeispiel rein beispielhaft nicht mechanisch, sondern elektrisch, das heißt, es werden bei beziehungsweise für die Überführung keine mechanischen Komponenten bewegt. Es können allerdings auch erfindungsgemäße High-Side-Schalter 100 ausgeführt werden, bei welchen die besagte Überführung mechanisch oder ganz anders vonstatten geht. Des Weiteren können auch erfindungsgemäße High-Side-Schalter 100 realisiert werden, bei welchen ein Wechsel der Stellung des ersten Eingangs 31 veranlasst durch das Stellmittel 12 automatisch immer dann erfolgt, wenn der Ultraschallsensor in einen Sendebetrieb überführt wird. In einem solchen Fall kann der High-Side-Schalter 100 beispielsweise dazu ausgebildet sein, den ersten Eingang 31 von der zweiten Stellung in die erste Stellung zu überführen.

Der Komparator 30 umfasst des Weiteren einen Ausgang 33, welcher mit dem Steuereingang des Messtransistors 4 und dem Steuereingang des Leistungstransistors 6 elektrisch leitfähig verbunden ist. Mit anderen Worten ausgedrückt ist der Ausgang 33 des Komparators 30 in diesem ersten Ausführungsbeispiel rein beispielhaft mit dem Gate des Messtransistors 4 und dem Gate des Leistungstransistors 6 elektrisch leitfähig verbunden. Des Weiteren ist eine erste kalibrierbare Stromquelle 40 mit dem Steuereingang des Messtransistors 4 elektrisch leitfähig verbunden. Diese kalibrierbare Stromquelle 40 ist dazu ausgebildet, den Steuereingang, also in diesem ersten Ausführungsbeispiel das Gate des Messtransistors 4 mit einem Strom, genauer einem Kompensationsstrom zu beaufschlagen. Die Stromquelle 40 selbst kann dabei beliebig gewählt sein, also den Kompensationsstrom selbst generieren oder aus einer weiteren Quelle beziehen. In diesem Ausführungsbeispiel ist die kalibrierbare Stromquelle 40 rein beispielhaft mit einem elektrischen Potenzial verbindbar, welches das Potenzial des Energiespeichers, mit welchem der High-Side-Schalter 100 verbindbar ist, übersteigt.

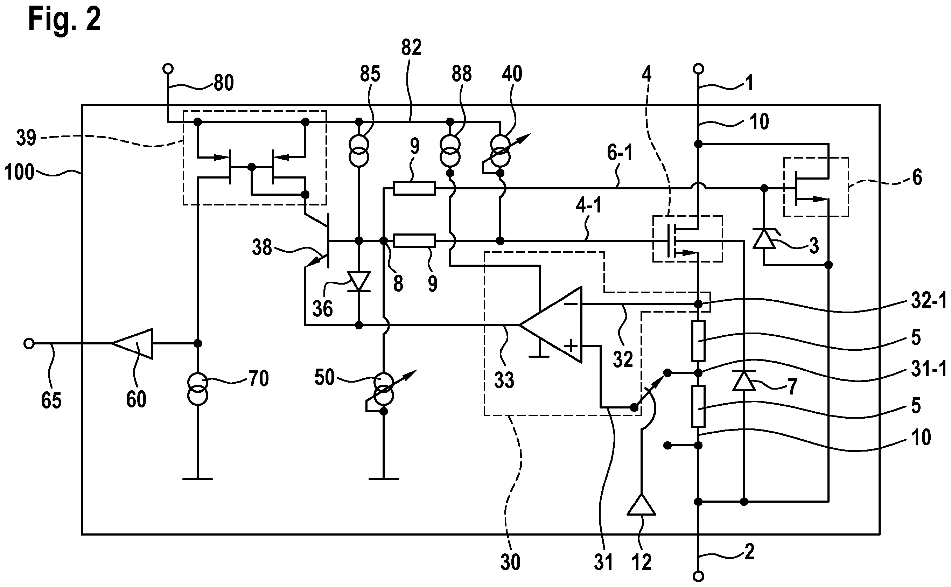

In diesem ersten Ausführungsbeispiel weisen der Messtransistor 4 und der Leistungstransistor 6 eine gleiche Kanallänge L auf, wobei die Kanalweite Wp des Leistungstransistors 6 um ein Vielfaches größer ist als die Kanalweite Ws des Messtransistors 4. In diesem ersten Ausführungsbeispiel ist die Kanalweite Wp des Leistungstransistors 6 rein beispielhaft zehnmal größer als die Kanalweite Ws des Messtransistors 4. Vernachlässigt man den Stromfehler des Leistungstransistors 6, führt dieses Kanalweitenverhältnis Wp/Ws im Betrieb des High-Side-Schalters 100 zu einem Stromfluss durch den Leistungstransistor 6, welcher ca. zehnmal so groß ist wie der Stromfluss durch den Messtransistor 4. Dies wird näher erklärt mit Bezug zu der Figur 2.

In Figur 2 ist ein zweites Ausführungsbeispiel eines erfindungsgemäßen High-Side-Schalters 100 gezeigt. Das in Figur 2 dargestellte zweite Ausführungsbeispiel ist im Wesentlichen identisch zu dem in Figur 1 gezeigten. Die in Figur 2 gleich bezeichneten Komponenten entsprechen denen der Figur 1, so dass das in der Beschreibung zu der Figur 1 zu diesen Komponenten Gesagte auch für die in Figur 2 gezeigten, gleich bezeichneten Komponenten Geltung hat. Die Figur 2 zeigt also im Wesentlichen das in Figur 1 dargestellte und oben beschriebene erste Ausführungsbeispiel, welches in diesem zweiten Ausführungsbeispiel um einige Komponenten erweitert wurde.

In diesem zweiten Ausführungsbeispiel eines erfindungsgemäßen High-Side-Schalters 100 sind der Steuereingang des Messtransistors 4 und der Steuereingang des Leistungstransistors 6 über jeweils eine elektrisch leitfähige Verbindung 4-1, 6-1 an einem Kreuzungspunkt 8 miteinander verbunden. Ferner ist in diesem zweiten Ausführungsbeispiel eine zweite kalibrierbare Stromquelle 50 mit dem Kreuzungspunkt 8 elektrisch leitfähig verbunden. Hingegen ist der Stromausgang der ersten kalibrierbaren Stromquelle 40 elektrisch leitfähig mit der elektrisch leitfähigen Verbindung 4-1 zwischen dem Steuereingang des Messtransistors 4 und dem Kreuzungspunkt 8 verbunden, wobei sowohl in dieser elektrisch leitfähigen Verbindung 4-1 zwischen dem Steuereingang des Messtransistors 4 und dem Kreuzungspunkt 8 als auch in der elektrisch leitfähigen Verbindung 6-1 zwischen dem Steuereingang des Leistungstransistors 6 und dem Kreuzungspunkt 8 jeweils ferner ein optionaler Vorwiderstand 9 angeordnet ist. Ferner ist der Ausgang 33 des Komparators 30 über eine optionale Diode 36 elektrisch leitfähig mit dem Kreuzungspunkt 8 verbunden, welcher seinerseits elektrisch leitfähig mit dem Steuereingang eines Transistors 38, in diesem zweiten Ausführungsbeispiel der Basis eines Bipolar-Transistors verbunden ist. Der Emitter-Anschluss eben dieses Transistors 38 ist mit dem Ausgang 33 des Komparators 30 verbunden, während der Kollektor-Anschluss des Transistors 38 elektrisch leitfähig mit einer Stromspiegel-Schaltung 39 verbunden ist. Der Ausgang der Stromspiegel-Schaltung 39 ist mit einer Treiberstufe verbunden, welche einen auch als Puffer bezeichneten Buffer 60 und eine Stromquelle 70 umfasst. Die Treiberstufe kann alternativ allerdings auch einen Schmitt-Trigger 60 oder eine andere Komponenten anstelle eines Buffers 60 umfassen. Der Buffer 60 ist dazu ausgebildet, ein mit dem High-Side-Schalter 100 verbindbares Bussystem mit einem High-Signal zu beaufschlagen. Zu diesem Zweck ist der High-Side-Schalter 100 über einen weiteren Anschluss 65 desselben mit einem Bussystem verbindbar. Der High-Side-Schalter 100 umfasst ferner einen Versorgungsanschluss 80, welcher mit einer Versorgungsleitung 82 elektrisch leitfähig verbunden ist, über welche dem High-Side-Schalter 100 in diesem zweiten Ausführungsbeispiel rein beispielhaft ein Potenzial zuführbar ist, welches größer ist als das von der Energiequelle an den ersten Anschluss 1 des High-Side-Schalters 100 bereitstellbare Potenzial. An diese Versorgungsleitung 82 sind die Source-Anschlüsse der von der Stromspiegel-Schaltung 39 umfassten Transistoren angeschlossen. Ferner ist die erste kalibrierbare Stromquelle 40 rein beispielhaft an diese Versorgungsleitung 82 angeschlossen sowie zwei weitere Stromquellen 85, 88. Die erste weitere Stromquelle 85 ist ferner elektrisch leitfähig mit dem Kreuzungspunkt 8, der Anode der Diode 36 und dem Basis-Anschluss des Bipolar-Transistors 38 verbunden. Sie dient insbesondere der Bereitstellung eines Komparatorabsenkstroms. Die zweite weitere Stromquelle 88 dient der Speisung eines der Versorgungsspannungsanschlüsse des Transkonduktanzverstärkers des Komparators 30, dessen verbleibender Versorgungsspannungsanschluss in diesem zweiten Ausführungsbeispiel auf Masse liegt. Des Weiteren umfasst der High-Side-Schalter 100 in diesem zweiten Ausführungsbeispiel rein beispielhaft eine dem Überspannungsschutz dienende optionale Zener-Diode 3. Die Kathode dieser Zener-Diode 3 ist elektrisch leitfähig mit dem Gate-Anschluss, also mit dem Steuereingang des Leistungstransistors 6 verbunden, während die Anode dieser Zener-Diode 3 elektrisch leitfähig mit dem Source-Anschluss des Leistungstransistors 6 verbunden ist. Eine Weitere Diode in Figur 2 stellt die Bulk-Diode 7 des Messtransistors 4 schematisch dar. Die Kathode dieser Bulk-Diode 7 ist elektrisch leitfähig mit dem Bulk-Anschluss des Messtransistors 4 verbunden, während die Anode dieser Bulk-Diode 7 elektrisch leitfähig mit dem zweiten Anschluss 2 des High-Side-Schalters 100 verbunden ist.

Mittels des High-Side-Schalters 100 soll die Versorgung der Ultraschallsensoren über eine separate Stromversorgungsleitung, welche vorliegend in dem Strompfad 10 gegeben ist, realisiert werden. In einem Gesamtsystem, welches den Energiespeicher, den High-Side-Schalter 100, ein mit diesem verbundenes Bussystem und mit dem High-Side-Schalter 100 verbundene Ultraschallsensoren umfasst, stellt dies eine günstige Lösung dar, da Ultraschallsensoren derzeit im Sendebetrieb eine Stromaufnahme von bis zu 550 mA erfordern. Sind mehrere Ultraschallsensoren mit dem High-Side-Schalter 100 verbunden, stellen diese im Betrieb sendende Teilnehmer im Bussystem dar, wodurch sich die Stromaufnahme der Sensoren entsprechend multipliziert. Dies macht bei den meisten anderen Lösungen entsprechende Spannungsstabilisierungsmechanismen zur Kompensation des Spanungsabfalls am Leistungstransistor 6 erforderlich.

Befindet sich ein mit dem High-Side-Schalter 100 verbundener Sensor nicht im Sendebetrieb, befindet sich der erste Eingang 31 des Komparators 30 in der zweiten Stellung, in welcher der Verbindungspunkt 31-1 des ersten Eingangs 31 mit dem Strompfad 10 zwischen dem zweiten Anschluss 2 des High-Side-Schalters 100 und der Gruppe der beiden unmittelbar aufeinander folgenden Widerstände 5 liegt. In dieser zweiten Stellung liegen beide Widerstände 5 zwischen den Verbindungspunkten 31-1, 32-1 der beiden Eingänge 31, 32 mit dem Strompfad 10. Durch den Komparator 30 wird die Spannung am Steuereingang, also am Gate des Messtransistors 4 und damit auch die Spannung am Steuereingang beziehungsweise am Gate des Leistungstransistors 6 dann so weit zurückgeregelt, bis das Produkt aus der Summe der Widerstandswerte der Widerstände 5 und dem Stromfluss durch den Messtransistor der Komparatorspannung, also in diesem zweiten Ausführungsbeispiel rein beispielhaft 18 mV entspricht. Mit anderen Worten ausgedrückt regelt der Komparator 30 die oben genannten Spannungen so weit zurück, bis die Bedingung 18 mV=(R₅₋₁+R₅₋₂)*Isense erfüllt ist, wobei R₅₋₁ der Wert des oberen der beiden Widerstände 5 ist, welcher unmittelbar auf den Messtransistor 4 folgend angeordnet ist und R₅₋₂ der Wert des unteren der beiden Widerstände 5 ist, auf welchen unmittelbar der zweite Anschluss 2 folgt. Isense entspricht dem Wert des Stromflusses durch den Messtransistor 4.

Befindet sich der erste Eingang 31 des Komparators 30 hingegen in der ersten Stellung, regelt der Komparator 30 die oben bezeichneten Spannungen an den Steuereingängen dann so weit zurück, bis das Produkt aus dem zwischen den beiden Verbindungspunkten 32-1, 31-1 befindlichem Widerstand 5 und dem Stromfluss durch dem Messtransistor 4 der Komparatorspannung, also in diesem zweiten Ausführungsbeispiel rein beispielhaft 18 mV entspricht. Mit anderen Worten ausgedrückt regelt der Komparator 30 die oben genannten Spannungen dann so weit zurück, bis die Bedingung 18 mV=R₅₋₁*Isense erfüllt ist.

Für einen geringen Strom wird der erste Eingang 31 des Komparators 30 also in die zweite Stellung, das heißt so geschaltet, dass beide Widerstände 5 im Sensepfad, also im Strompfad 10 aktiv sind. Beispielsweise sind in diesem zweiten Ausführungsbeispiel die Werte der beiden Widerstände 5 mit R₅₋₁+R₅₋₂ = 900 mOhm gewählt, so dass sich in der zweiten Stellung des ersten Eingangs 31 ein Stromfluss in Höhe von 20 mA durch den Messtransistor 4 ergibt. Durch die Wahl der Kanalweiten Wp, Ws von Leistungs- und Messtransistor 6, 4 (siehe oben, Wp=10, Ws=1) führt das Übersetzungsverhältnis Wp/Ws bei gleicher Kanallänge L der Transistoren zu einem Stromfluss von 200 mA durch den Leistungstransistor 6. Auf Grund der Gegenkopplung der beiden Widerstände 5 ergibt sich im Leistungstransistor 6 bei einer effektiven Gate-Source-Spannung am Steuereingang des Leistungstransistors von U_{GS} ≈3 V dann ein Spannungsfehler von ca. 18 mV, welcher allerdings vernachlässigbar ist.

Ist jedoch - wie bei High-Side-Schaltern 100 für Ultraschallsensoren üblich und in diesem zweiten Ausführungsbeispiel der Fall - der Wert des oberen Widerstands 5 mit R₅₋₁ = 90 mOhm gewählt und wird der erste Eingang 31, also der Sense-Abgriff, in die erste Stellung überführt, das heißt auf Power geschaltet, beispielsweise weil einer oder mehrere der Ultraschallsensoren in den Sendebetrieb überführt werden, so liegen 18 mV an dem oberen Widerstand 5 an und fließen maximal 200 mA durch den Messtransistor 4, da die Spannung am Steuereingang/Gate des Messtransistors 4 bei Erreichen des Spannungsabfalls von 18 mV am oberen Widerstand 5 durch den Komparator 30 zurückgeregelt wird. Es kann also ein Maximalstrom von 200 mA fließen. Aufgrund des oben erwähnten Übersetzungsverhältnisses von Wp/Ws würde man dann einen Stromfluss durch den Leistungstransistor 6 in Höhe von 2 A erwarten. Bedingt durch die Gegenkopplung der beiden Widerstände 5 mit R₅₋₁+R₅₋₂ beträgt die Fehlspannung am Steuereingang/Gate des Leistungstransistors 6 nun allerdings nicht mehr 18 mV, sondern 180 mV (200 mA*900 mOhm=180 mV). Diese Fehlspannung ist in aller Regel nicht mehr vernachlässigbar, da sich durch selbige ein grober Stromfehler im Strompfad 10 ergibt. Aus diesem Grund ist die erste kalibrierbare Stromquelle 40 vorgesehen, welche dazu ausgebildet ist, durch Zuschaltung eines ersten Kompensationsstromes Ik1 auf den Steuereingang des Messtransistors 4 den sich aus der Fehlspannung ergebenden Stromfehler zu kompensieren. Dies erfolgt in diesem zweiten Ausführungsbeispiel rein beispielhaft, indem sowohl die erste als auch die zweite kalibrierare Stromquelle 40, 50 einen identischen Kompensationsstrom Ik1 = Ik2 bereitstellen, wobei das Produkt aus dem Widerstandswert Rₖ₁ des dem Steuereingang des Messtransistors 4 vorgeschalteten Vorwiderstands 9 und dem Kompensationsstrom Ik1 der ersten kalibrierbaren Stromquelle 40 gerade entsprechend der Fehlspannung am Steuereingang des Leistungstransistors 6 gewählt wird. Es muss mit anderen Worten ausgedrückt also die Bedingung Ik1*Rₖ₁=180 mV erfüllt werden, was in diesem zweiten Ausführungsbeispiel rein beispielhaft erreicht wird, indem der Widerstandswert Rₖ₁ des Vorwiderstands 9 mit Rₖ₁ = 20 kOhm gewählt wird, während der Kompensationsstrom der ersten kalibrierbaren Stromquelle 40 rein beispielhaft mit 9 µA gewählt wird. Es können aber auch erfindungsgemäße High-Side-Schalter 100 mit einer zweiten kalibrierbaren Stromquelle 50 ausgeführt werden, welche dazu ausgebildet ist, einen Kompensationsstrom Ik2 in den Kreuzungspunkt 8 einzuspeisen, welcher von dem Kompensationsstrom Ik1 der ersten kalibrierbaren Stromquelle 40 verschieden ist.

Zu beachten ist dabei, dass der von der ersten weiteren Stromquelle 85 bereitgestellte Komparatorabsenkstrom immer in der Lage ist, die Kompensationsströme Ik1, Ik2 der ersten und zweiten kalibrierbaren Stromquelle 40, 50 zu treiben. Ohne dass das Übersetzungsverhältnis Wp/Ws angepasst werden muss oder weitere Leistungstransistoren 6 zum Einsatz kommen müssen, kann das oben beschriebene Problem des Stromfehlers somit gelöst werden. Ein weiterer Vorteil dieser Kompensationsmethodik ist, dass mit wenig Flächenzuwachs der zu limitierende Strom über kalibrierbare Stromquellen 40, 50 durch Bereitstellung von Strömen Ik1/Ik2 auf vorbestimmte Sollwerte getrimmt werden kann. Der Kompensationsstrom Ik2 der zweiten kalibrierbaren Stromquelle 50 wird benötigt, um die Ausgangsstufe des Komparators 30 nicht unnötig zu belasten. Durch das einfache Sensieren des Stromes in den Komparator 30 erhält man mit wenig Flächenmehraufwand außerdem ein Digitalsignal, mit dem sich der Zustand des High-Side-Schalters 100 diagnostizieren lässt. Bei Vorliegen eines High-Signals würde mehr Strom im High-Side-Schalter 100 fließen als theoretisch erlaubt und somit kann ein Kurzschluss gegen Masse, oder gegen ein niederohmiges, tiefes Potenzial, erkannt werden. Ein solches High-Signal kann beispielsweise über den Buffer 60 und über den weiteren Anschluss 65 an ein Bussystem ausgegeben werden.

Die zu diesem zweiten Ausführungsbeispiel beschriebenen Werte, wie beispielsweise die Werte R₅₋₁+R₅₋₂ der Widerstände 5, der Ströme durch den Messtransistor 4 beziehungsweise durch den Leistungstransistor 6, der Spannungen an den Steuereingängen dieser Transistoren 4, 6 oder der Fehlspannung am Steuereingang des Leistungstransistors 6 sind lediglich rein beispielhaft. Es können auch andere erfindungsgemäße High-Side-Schalter 100 realisiert werden, bei welchen diese und andere Werte von den oben beschriebenen abweichen. Auch kann ein erfindungsgemäßer High-Side-Schalter 100 mehr, weniger oder andere Komponenten aufweisen als die oben beschriebenen. Ferner können auch erfindungsgemäße High-Side-Schalter 100 mit mehr als zwei Widerständen 5 im Strompfad 10 realisiert werden. In solchen Ausführungen können dann mehr als zwei verschiedene Stromstufen von dem High-Side-Schalter 100 bereitgestellt werden. Der erste Eingang 31 des Komparators 30 kann in solchen Ausführungsbeispielen zwischen mehr als zwei verschiedenen Stellungen umgeschaltet werden.

Somit bewirkt die Erfindung eine Verringerung des eingangs erwähnten Einschaltwiderstandes R_{DSon} des Messtransistors 4 und ermöglicht gleichzeitig eine einfache Diagnose mit Trimmmöglichkeit und verschiedenen Stromlimits, ohne wesentlichen Übersetzungsfehler, der bei einer Standardlösung entstehen würde.

## Patentansprüche

1. High-Side-Schalter (100) für die Stromversorgung mindestens eines Sensors, umfassend,
- zwei Anschlüsse (1, 2);
- einen Strompfad (10), über welchen die Anschlüsse (1, 2) miteinander elektrisch leitfähig verbunden sind und innerhalb welchem ein Messtransistor (4) und mindestens zwei Widerstände (5) einander in Reihe geschaltet sind,
wobei der High-Side-Schalter (100) ferner umfasst:
- einen Leistungstransistor (6), welcher dem Strompfad (10) parallel geschaltet ist,
- einen Komparator (30), aufweisend:
zwei Eingänge (31, 32), von denen einer fix mit dem Strompfad (10) verbunden und einer derart variabel mit dem Strompfad (10) verbindbar ist, dass die Anzahl der zwischen den Verbindungspunkten der Eingänge (31, 32) mit dem Strompfad (10) liegenden Widerstände (5) veränderbar ist, einen Ausgang (33), welcher mit dem Steuereingang des Messtransistors (4) und des Leistungstransistors (6) elektrisch leitfähig verbunden ist, wobei eine erste kalibrierbare Stromquelle (40) mit dem Steuereingang des Messtransistors (4) elektrisch leitfähig verbunden ist, **dadurch gekennzeichnet, dass** die erste kalibrierbare Stromquelle (40) dazu ausgebildet ist, eine sich aufgrund der Gegenkopplung der Widerstände (5) am Steuereingang des Leistungstransistors (6) ergebende Fehlspannung durch Zuschaltung eines ersten Kompensationsstromes (Ik1) auf den Steuereingang des Messtransistors (4) zu kompensieren.

2. High-Side-Schalter (100) nach Anspruch 1, wobei der erste der Eingänge (31) derart verstellbar ausgebildet ist, dass in einer ersten Stellung desselben ein Widerstand (5) und in einer zweiten Stellung beide Widerstände (5) zwischen den Verbindungspunkten der Eingänge (31, 32) mit dem Strompfad (10)) innerhalb des Strompfads (10) liegen, wobei der High-Side-Schalter (100) ferner ein Stellmittel (12) zum Stellungswechsel des ersten Eingangs (31) umfasst.

3. High-Side-Schalter (100) nach einem der vorhergehenden Ansprüche, wobei der Komparator (30) einen Emitterkomparator, insbesondere einen 18 mV-Emitterkomparator aufweist, welcher einen Transkonduktanzverstärker umfasst.

4. High-Side-Schalter (100) nach einem der vorhergehenden Ansprüche, wobei es sich sowohl bei dem Messtransistor (4) als auch bei dem Leistungstransistor (6) um Feldeffekttransistoren mit gleicher Kanallänge (L) handelt, wobei die Kanalweite (Wp) des Leistungstransistors (6) um ein Vielfaches größer ist als die Kanalweite (Ws) des Messtransistors (4).

5. High-Side-Schalter (100) nach einem der vorhergehenden Ansprüche, wobei der Steuereingang des Messtransistors (4) und der Steuereingang des Leistungstransistors (6) über jeweils eine elektrisch leitfähige Verbindung (4-1, 6-1) an einem Kreuzungspunkt (8) miteinander verbunden sind und wobei eine zweite kalibrierbare Stromquelle (50) mit dem Kreuzungspunkt (8) elektrisch leitfähig verbunden ist.

6. High-Side-Schalter (100) nach Anspruch 5, wobei der Stromausgang der ersten kalibrierbaren Stromquelle (40) elektrisch leitfähig mit der elektrisch leitfähigen Verbindung (4-1) zwischen dem Steuereingang des Messtransistors (4) und dem Kreuzungspunkt (8) verbunden ist, und wobei in dieser elektrisch leitfähigen Verbindung (4-1) zwischen dem Steuereingang des Messtransistors (4) und dem Kreuzungspunkt (8) ferner ein Vorwiderstand (9) angeordnet ist.

7. High-Side-Schalter (100) nach einem der vorhergehenden Ansprüche, wobei die zweite kalibrierbare Stromquelle (50) dazu ausgebildet ist, einen zweiten Kompensationsstrom (Ik2) in den Kreuzungspunkt (8) einzuspeisen, welcher dem ersten Kompensationsstrom (Ik1) entspricht.

8. High-Side-Schalter (100) nach einem der Ansprüche 6 oder 7, wobei das Produkt aus dem Widerstandswert des Vorwiderstands (9) und des ersten Kompensationsstromes (Ik1) im Betrieb des High-Side-Schalters (100) dem Produkt aus dem durch den Komparator (30) eingeregelten Maximalstrom durch den Messtransistor (4) und der Summe aus den Widerstandswerten der mindestens zwei Widerstände (5) entspricht.

9. High-Side-Schalter (100) nach einem der vorhergehenden Ansprüche, wobei die erste kalibrierbare Stromquelle (40) dazu ausgebildet ist, den Stromfluss durch den Strompfad (10) auf einen vorbestimmten Sollwert zu trimmen.

## Claims

1. High-side switch (100) for supplying current to at least one sensor, comprising:
- two connections (1, 2);
- a current path (10), via which the connections (1, 2) are electrically conductively connected to one another, and within which a measuring transistor (4) and at least two resistors (5) are connected in series with one another,
wherein the high-side switch (100) also comprises:
- a power transistor (6) that is connected in parallel with the current path (10),
- a comparator (30) having:
two inputs (31, 32), of which one is fixedly connected to the current path (10) and one can be variably connected to the current path (10) in such a way that the number of resistors (5) located between the connecting points of the inputs (31, 32) to the current path (10) can be changed, one output (33) that is electrically conductively connected to the control input of the measuring transistor (4) and of the power transistor (6), wherein a first calibratable current source (40) is electrically conductively connected to the control input of the measuring transistor (4), **characterized in that** the first calibratable current source (40) is designed to compensate for an error voltage, resulting on account of the negative feedback of the resistors (5) at the control input of the power transistor (6), by switching a first compensation current (Ik1) to the control input of the measuring transistor (4).

2. High-side switch (100) according to Claim 1, wherein the first of the inputs (31) is designed to be adjustable in such a way that, in a first position thereof, one resistor (5) and, in a second position, both resistors (5), between the connecting points of the inputs (31, 32) to the current path (10), are within the current path (10), wherein the high-side switch (100) also comprises an actuating means (12) for changing the position of the first input (31).

3. High-side switch (100) according to either of the preceding claims, wherein the comparator (30) has an emitter comparator, in particular an 18 mV emitter comparator, which comprises a transconductance amplifier.

4. High-side switch (100) according to one of the preceding claims, wherein both the measuring transistor (4) and the power transistor (6) are field effect transistors with the same channel length (L), wherein the channel width (Wp) of the power transistor (6) is greater than the channel width (Ws) of the measuring transistor (4) by a multiple.

5. High-side switch (100) according to one of the preceding claims, wherein the control input of the measuring transistor (4) and the control input of the power transistor (6) are connected to one another at an intersection point (8) via a respective electrically conductive connection (4-1, 6-1), and wherein a second calibratable current source (50) is electrically conductively connected to the intersection point (8).

6. High-side switch (100) according to Claim 5, wherein the current output of the first calibratable current source (40) is electrically conductively connected to the electrically conductive connection (4-1) between the control input of the measuring transistor (4) and the intersection point (8), and wherein a series resistor (9) is also arranged in this electrically conductive connection (4-1) between the control input of the measuring transistor (4) and the intersection point (8).

7. High-side switch (100) according to one of the preceding claims, wherein the second calibratable current source (50) is designed to feed a second compensation current (Ik2) that corresponds to the first compensation current (Ik1) into the intersection point (8).

8. High-side switch (100) according to either of Claims 6 and 7, wherein the product of the resistance value of the series resistor (9) and the first compensation current (Ik1), during operation of the high-side switch (100), corresponds to the product of the maximum current, which is set by the comparator (30), through the measuring transistor (4) and the sum of the resistance values of the at least two resistors (5).

9. High-side switch (100) according to one of the preceding claims, wherein the first calibratable current source (40) is designed to trim the current flow through the current path (10) to a predetermined target value.

## Revendications

1. Commutateur côté haut (100) pour alimenter en courant au moins un capteur, comprenant
- deux bornes (1, 2) ;
- un trajet de courant (10) par lequel les bornes (1, 2) sont reliées l'une à l'autre de manière électriquement conductrice et à l'intérieur duquel un transistor de mesure (4) et au moins deux résistances (5) sont connectés en série les uns avec les autres,
le commutateur côté haut (100) comprenant en outre :
- un transistor de puissance (6) qui est connecté en parallèle au trajet de courant (10),
- un comparateur (30), présentant :
deux entrées (31, 32) dont l'une est reliée de manière fixe au trajet de courant (10) et l'autre peut être reliée de manière variable au trajet de courant (10) de telle sorte que le nombre des résistances (5) situées entre les points de connexion des entrées (31, 32) au trajet de courant (10) est variable,
une sortie (33) qui est reliée de manière électriquement conductrice à l'entrée de commande du transistor de mesure (4) et du transistor de puissance (6), une première source de courant (40) pouvant être étalonnée étant reliée de manière électriquement conductrice à l'entrée de commande du transistor de mesure (4),
**caractérisé en ce que** la première source de courant (40) pouvant être étalonnée est réalisée pour compenser une tension erronée résultant en raison du contre-couplage des résistances (5) à l'entrée de commande du transistor de puissance (6) par la mise en circuit d'un premier courant de compensation (Ik1) au niveau de l'entrée de commande du transistor de mesure (4).

2. Commutateur côté haut (100) selon la revendication 1, dans lequel la première des entrées (31) est réalisée de manière réglable de telle sorte que dans une première position de celle-ci, une résistance (5), et dans une deuxième position les deux résistances (5), se trouve(nt) à l'intérieur du trajet de courant (10) entre les points de connexion des entrées (31, 32) au trajet de courant (10), le commutateur côté haut (100) comprenant en outre un moyen de réglage (12) pour un changement de position de la première entrée (31).

3. Commutateur côté haut (100) selon l'une quelconque des revendications précédentes, dans lequel le comparateur (30) présente un comparateur émetteur, en particulier un comparateur émetteur 18 mV qui comprend un amplificateur à transconductance.

4. Commutateur côté haut (100) selon l'une quelconque des revendications précédentes, dans lequel à la fois le transistor de mesure (4) et le transistor de puissance (6) sont des transistors à effet de champ de même longueur de canal (L), la largeur de canal (Wp) du transistor de puissance (6) étant plusieurs fois supérieure à la largeur de canal (Ws) du transistor de mesure (4).

5. Commutateur côté haut (100) selon l'une quelconque des revendications précédentes, dans lequel l'entrée de commande du transistor de mesure (4) et l'entrée de commande du transistor de puissance (6) sont reliées l'une à l'autre par respectivement une connexion électriquement conductrice (4-1, 6-1) en un point de croisement (8), et dans lequel une deuxième source de courant (50) pouvant être étalonnée peut être reliée de manière électriquement conductrice au point de croisement (8).

6. Commutateur côté haut (100) selon la revendication 5, dans lequel la sortie de courant de la première source de courant (40) pouvant être étalonnée est reliée de manière électriquement conductrice à la connexion (4-1) électriquement conductrice entre l'entrée de commande du transistor de mesure (4) et le point de croisement (8), et dans lequel une résistance série (9) est en outre disposée dans cette connexion (4-1) électriquement conductrice entre l'entrée de commande du transistor de mesure (4) et le point de croisement (8).

7. Commutateur côté haut (100) selon l'une quelconque des revendications précédentes, dans lequel la deuxième source de courant (50) pouvant être étalonnée est réalisée pour alimenter un deuxième courant de compensation (Ik2) dans le point de croisement (8) qui correspond au premier courant de compensation (Ik1).

8. Commutateur côté haut (100) selon l'une quelconque des revendications 6 ou 7, dans lequel le produit de la valeur de résistance de la résistance série (9) et du premier courant de compensation (Ik1) pendant le fonctionnement du commutateur côté haut (100) correspond au produit du courant maximal à travers le transistor de mesure (4), régulé par le comparateur (30), et de la somme des valeurs de résistance des au moins deux résistances (5).

9. Commutateur côté haut (100) selon l'une quelconque des revendications précédentes, dans lequel la première source de courant (40) pouvant être étalonnée est réalisée pour ajuster le flux de courant à travers le trajet de courant (10) à une valeur de consigne prédéterminée.
